# EUROPÄISCHE PATENTANMELDUNG

(11) **EP 1 968 123 A2**
(43) Veröffentlichungstag der Anmeldung: **10.09.2008**
(21) Anmeldenummer: 08003639.5
(22) Anmeldetag: 28.02.2008
(51) Int. Cl.: H01L 31/18, H01L 31/0232

(54) **Vefahren zur Herstellung von Siliziumsolarzellen**

(30) Priorität: 28.02.2007 DE 102007009654; 04.08.2007 DE 102007036921
(71) Anmelder: Centrotherm Photovoltaics Technology GmbH, 89143 Blaubeuren (DE)
(72) Erfinder: Nussbaumer, Hartmut, Dr., 78479 Reichenau (DE); Fath, Peter, Dr., 78464 Konstanz (DE); Melnyk, Ihor, Dr., 78465 Konstanz (DE)
(74) Vertreter: Heyerhoff, Markus

(57) **Zusammenfassung**

Die Erfindung betrifft ein Verfahren zur Herstellung von Solarzellen bei welchem Borglas (104; 124) oder eine hochdotierte Siliziumschicht (406) auf wenigstens einen Teil der Oberfläche einer Siliziumscheibe (102) aufgebracht wird (12; 32), wobei beim Ätzen (16) der Siliziumscheibe (102) in einer Texturätzlösung das Borglas (104; 124) oder die hochdotierte Siliziumschicht (406) als Ätzbarriere verwendet wird. Daneben betrifft die Erfindung ein Verfahren zur Herstellung von Solarzellen, bei welchem aluminiumhaltiges Material (304) auf einen Teil der Oberfläche einer Siliziumscheibe (302) aufgebracht wird, das Aluminium (304) wenigstens teilweise in die Siliziumscheibe (302) einlegiert wird (212; 232) und nach dem wenigstens teilweisen Einlegieren (212; 236) des Aluminiums (304) ein Phosphorglas (314) auf der Siliziumscheibe (302) ausgebildet und Verunreinigungen cogegettert werden.

## Beschreibung

Die Erfindung betrifft Verfahren zur Herstellung von Solarzellen gemäß dem Oberbegriff des Anspruchs 1, gemäß dem Oberbegriff des Anspruchs 19 sowie gemäß dem Oberbegriff des Anspruchs 21. Weiterhin betrifft sie Vorrichtungen zur Durchführung dieser Verfahren sowie Solarzellen.

Solarzellen zur Gewinnung elektrischen Stromes aus Licht sind seit geraumer Zeit bekannt. Um diese Technologie für die Energiegewinnung in relevantem Umfang nutzen zu können, bedurfte es jedoch der Umsetzung von Laborfertigungsprozessen in industriell anwendbare Herstellungsverfahren. In dieser Hinsicht haben in vergangener Zeit vor allem Siliziumsolarzellen große Bedeutung erlangt, hierunter insbesondere auf Basis von mono- oder multikristallinem Silizium hergestellte Solarzellen. Solch kristalline Solarzellen werden gegenwärtig bereits in großen Stückzahlen gefertigt und zur terrestrischen Energiegewinnung eingesetzt.

Inwieweit diese Technologie zukünftig zur Energiegewinnung beitragen wird, hängt davon ab, mit welcher Konversionseffizienz (Wirkungsgrad) mittels Solarzellen einfallende Sonnenstrahlung in elektrische Energie umgewandelt werden kann und mit welchen Kosten dies verbunden ist. Dabei besteht ein enges Wechselspiel zwischen dem Wirkungsgrad der Solarzellen und den Fertigungskosten. So sind bereits Verfahren bekannt, mit welchen Solarzellen mit sehr hohem Wirkungsgrad von deutlich über 20 % hergestellt werden können. Hierbei handelt es sich jedoch überwiegend um Laborverfahren, die für eine Fertigung im industriellen Maßstab nicht geeignet sind, da sie eine sehr aufwändige Prozessführung erfordern. Bedarf besteht jedoch an Herstellungsverfahren, welche in einen industriellen Fertigungsprozess überführbar sind.

Die Aufgabe der vorliegenden Erfindung besteht daher darin, Verfahren zur Verfügung zu stellen, mit welchen aufwandsgünstig Solarzellen mit möglichst hohem Wirkungsgrad herstellbar sind.

Diese Aufgabe wird gelöst durch ein Verfahren mit den Merkmalen des Anspruchs 1, ein Verfahren mit den Merkmalen des Anspruchs 19 sowie durch ein Verfahren mit den Merkmalen des Anspruchs 21.

Vorteilhafte Weiterbildungen sind jeweils Gegenstand abhängiger Unteransprüche.

Weitere Aspekte der Erfindung bestehen darin, Vorrichtungen zur Durchführung der genannten Verfahren sowie aufwandsgünstig herstellbare Solarzellen mit möglichst hohem Wirkungsgrad zur Verfügung zu stellen.

Dies wird einerseits realisiert durch eine Vorrichtung gemäß Anspruch 38, andererseits durch Solarzellen gemäß den Ansprüchen 40 oder 41. Vorteilhafte Weiterbildungen sind wiederum jeweils Gegenstand abhängiger Unteransprüche.

Der Grundgedanke der Erfindung besteht darin, in einer industriellen Fertigung beherrschbare Verfahrensschritte einzusetzen und diese derart aufeinander abzustimmen, dass sich synergetische Effekte derart ergeben, dass die Anzahl der Prozessschritte und somit der Aufwand für die Solarzellenfertigung reduziert werden kann.

Das erfindungsgemäße Verfahren nach Anspruch 1 sieht hierzu vor, dass auf wenigstens einem der Teil der Oberfläche einer Siliziumscheibe ein Borsilikatglas, kurz als Borglas bezeichnet, aufgebracht wird, welches bei einem nachfolgenden Ätzen der Siliziumscheiben in einer Texturätzlösung als Ätzbarriere verwendet wird. Unter einer Ätzbarriere wird vorliegend ein Material verstanden, welches gegenüber der Texturätzlösung resistenter ist als Silizium oder gar von der Texturätzlösung überhaupt nicht angegriffen wird. Die Siliziumscheibe kann p- oder n-dotiert sein.

Zur Realisierung des Erfindungsgedankens sieht das erfindungsgemäße Verfahren nach Anspruch 19 hingegen vor, eine hochdotierte Siliziumschicht als Ätzbarriere gegenüber der Texturätzlösung zu verwenden.

Das erfindungsgemäße Verfahren nach Anspruch 21 sieht zur Verwirklichung des genannten Gedankens vor, dass aluminiumhaltiges Material auf einen Teil der Oberfläche einer Siliziumscheibe aufgebracht und wenigstens teilweise einlegiert wird. Im Weiteren werden nicht einlegiertes Aluminium und andere Bestandteile des aluminiumhaltigen Materials von der Siliziumscheibe wieder entfernt, ehe ein Phosphorsilikatglas, kurz als Phosphorglas bezeichnet, auf wenigstens einem weiteren Teil der Oberfläche der Siliziumscheibe ausgebildet und Phosphor in die Siliziumscheibe eindiffundiert wird. Der Phosphor kann beispielsweise aus dem Phosphorglas in die Siliziumscheibe hineindiffundiert werden, wie dies bei einer konventionellen Diffusion aus der Gasphase in einem Röhrendiffusionsofen (open tube furnace) der Fall ist. Grundsätzlich kann jedoch eine andere Phosphorquelle für den Phosphordiffusionsvorgang verwendet werden. Beispielsweise Phosphorsäure oder Phosphornitrid.

Der Phosphordiffusionsvorgang wird in jedem Fall derart geführt, dass in der Siliziumscheibe enthaltene Verunreinigungen in dem Phosphorglas und der Aluminium-Silizium-Legierung eingebunden werden, was üblicherweise als Gettern bezeichnet wird. Auf diese Weise kann ein Gettern von Verunreinigungen im Phosphorglas und in der Aluminium-Silizium-Legierung in einem gemeinsamen Hochtemperaturschritt erfolgen, was teilweise als Cogettern bezeichnet wird. Gegenüber einem einfachen Gettern in entweder Phosphorglas oder der Aluminium-Silizium-Legierung führt dies zu einem erhöhten Reinigungseffekt, was sich bei entsprechender Prozessführung in einem höheren Wirkungsgrad gefertigter Solarzellen niederschlägt. Die Siliziumscheibe braucht hierfür neben dem Phosphordiffusionsschritt, welcher zur Ausbildung eines p-n-Überganges ohnehin erforderlich ist, keinem weiteren Behandlungsschritt bei einer ähnlichen hohen Temperatur (über 800° C) ausgesetzt werden, da das Einlegieren des Aluminiums bereits ab einer Temperatur von 577° C erfolgen kann.

Vorrichtungen zur Durchführung eines erfindungsgemäßen Verfahrens weisen vorzugsweise eine Steuereinrichtung auf, mittels welcher die Vorrichtung gemäß diesem Verfahren ansteuerbar ist. Die Steuereinrichtung kann aus mehreren Steuereinheiten gebildet sein.

Im folgenden wird die Erfindungen anhand von Figuren näher erläutert. Soweit dies zweckmäßig erscheint, sind hierin gleiche Elemente mit denselben Bezugszeichen versehen. Es zeigen:
- Fig. 1a: Schematische Darstellung eines Ausführungsbeispiels eines erfindungsgemäßen Verfahrens, bei welchem ein Borglas als Ätzbarriere verwendet wird.
- Fig. 1b: Fortsetzung der Darstellung der Fig. 1a.
- Fig. 2a: Weiteres Ausführungsspeispiel eines erfindungsgemäßen Verfahrens, bei welchem das Borglas als Ätzbarriere verwendet wird. Überdies wird eine selektive Emitterstruktur ausgebildet.
- Fig. 2b: Fortsetzung der Darstellung der Fig. 2a.
- Fig. 3: Modifikation des Verfahrens aus den Figuren 2a und 2b bei welcher auf einer ersten und einer zweiten Seite der Siliziumscheibe gesondert Dielektrika abgeschieden werden.
- Fig. 4a: Ausführungsbeispiel eines erfindungsgemäßen Verfahrens, bei welchem ein Cogettern erfolgt.
- Fig. 4b: Fortsetzung der Darstellung in Fig. 4a.
- Fig. 5a: Ausführungsbeispiel eines erfindungsgemäßen Verfahrens, bei welchem ein Cogettern erfolgt. Zudem wird ein selektiver Emitter ausgebildet:
- Fig. 5b: Fortsetzung der Darstellung der Fig. 5a.
- Fig. 6: Ausführungsbeispiel eines erfindungsgemäßen Verfahrens, bei welchem eine hochdotierte Siliziumschicht als Ätzbarriere verwendet wird.

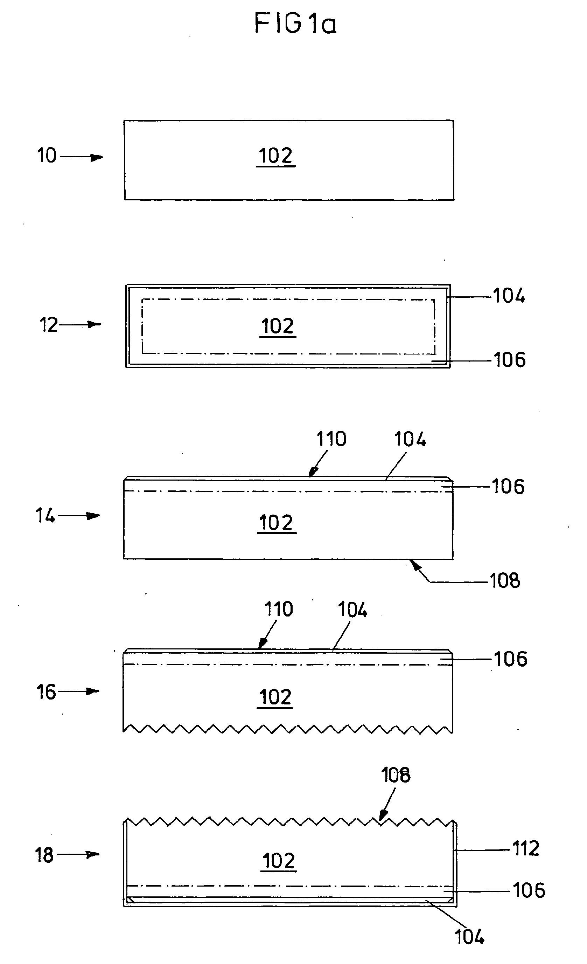

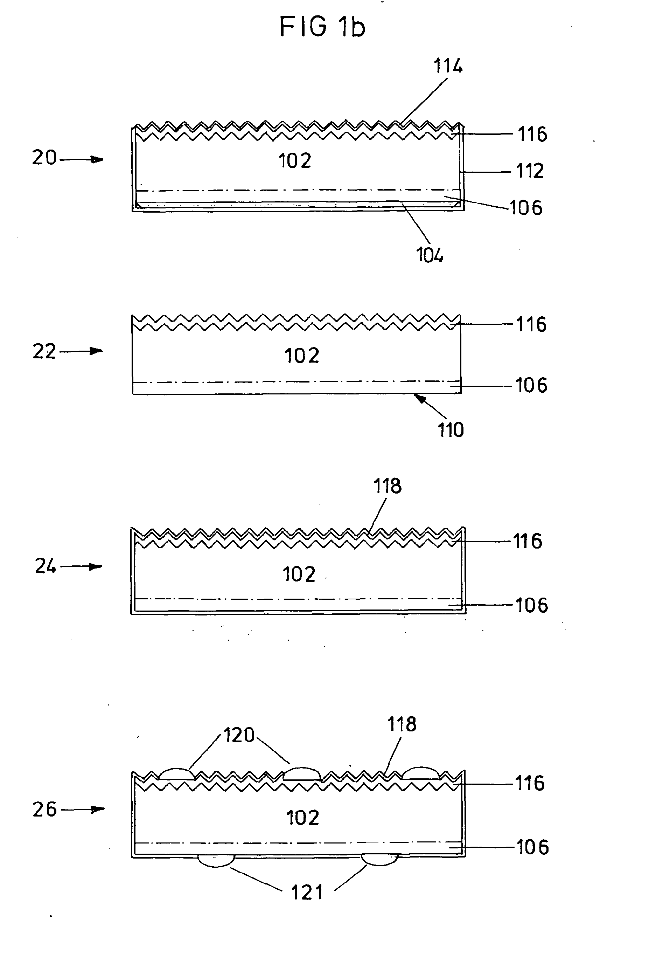

Die Fig. 1a und 1b illustrieren ein erstes Ausführungsbeispiel eines erfindungsgemäßen Verfahrens, bei welchem Borglas 104 als Ätzbarriere benutzt wird. Ausgangspunkt bildet eine Siliziumscheibe 102, welche p- oder n-dotiert sein kann und zunächst gereinigt wird 10. Eine solche Reinigung besteht typischerweise in einem an sich bekannten Überätzen 10 der gesamten Oberfläche der Siliziumscheibe 102. Hieran schließt sich eine Bordiffusion 12 an, welche im dargestellten Ausführungsbeispiel in einem Diffusionsofen erfolgt. Hierbei wird die Siliziumscheibe 102 einer borhaltigen, gasförmigen Verbindung ausgesetzt, beispielsweise BBr₃.
Infolgedessen wächst auf der Oberfläche der Siliziumscheibe 102 das Borglas 104 auf. Aus diesem Borglas 104 wird während der Diffusion, beispielsweise einer Diffusion in einem Quarzrohr, Bor in die Siliziumscheibe 102 eindiffundiert, wodurch der Bor-diffundierte Bereich 106 ausgebildet wird.

Eine Siliziumscheibe 102, üblicherweise als Wafer bezeichnet, weist zwei großflächige Seiten auf, welche vorliegend als erste Seite 108 und zweite Seite 110 bezeichnet werden. Die im Vergleich hierzu viel kleineren Seitenflächen werden der üblichen Bezeichnungsweise folgend in dieser Anmeldung als Randflächen oder Ränder bezeichnet. Ob letztlich die erste Seite 108 oder zweite Seite 110 als Vorderseite zu betrachten ist, hängt davon ab, ob es sich um eine p- oder n-dotierte Siliziumscheibe 102 handelt und eine npp⁺- oder eine pnn⁺-Solarzelle hergestellt wird. Als Vorderseite der Solarzelle wird dabei üblicherweise diejenige Seite bezeichnet, welche die größte Lichtempfindlichkeit besitzt, sodass ein Lichteinfall auf dieser Seite den größten Strom bewirkt. Dies schließt jedoch nicht aus, dass beide Seiten lichtempfindlich ausgeführt sind, sodass eine beidseitig lichtempfindliche oder bifaciale Solarzelle vorliegt.

Das erfindungsgemäße Verfahren nach den Fig. 1a und 1b wird vorzugsweise zur Herstellung einer mono- oder bifacialen p-Typ-Solarzelle verwendet, sodass eine npp⁺-Solarzelle erhalten wird. Hierzu werden das Borglas 104 sowie die darunter liegenden Bor-diffundierten Bereiche teilweise entfernt 14, im dargestellten Fall an der ersten Seite 108 sowie den Rändern der Siliziumscheibe 102. Nachfolgend wird die Siliziumscheibe 102 in einer Texturätzlösung geätzt 16. Als Texturätzlösung können bei den erfindungsgemäßen Verfahren an sich bekannte saure oder alkalische Texturätzlösungen Verwendung finden. Vorzugsweise werden alkalische Texturätzlösungen eingesetzt, besonders bevorzugt solche, welche Kaliumhydroxid und Isopropylalkohol enthalten. Infolge ergibt sich im Ausführungsbeispiel der Fig. 1a und 1b die schematisch wiedergegebene Texturierung an der Oberfläche der ersten Seite 108 der Siliziumscheibe 102.

Während des Texturätzens wird die zweite Seite 110 durch das dort vorhandene Borglas 104 vor dem Einwirken der Texturätzlösung geschützt. Das zuvor als Dotierungsquelle aufgebrachte Borglas 104 wird somit erfindungsgemäß als Ätzbarriere verwendet. In den ungeschützten Bereichen hingegen wird die Oberfläche der Siliziumscheibe durch Einwirkung der Texturätzlösung nasschemisch texturiert, wodurch die Oberfläche vergrößert und die Einkopplung einfallenden Lichts in die Siliziumscheibe 102 bzw. die fertige Solarzelle erhöht wird. Die Ränder werden, sofern sie nicht durch eine verbliebene Borglasschicht geschützt sind ebenfalls von der Texturätzlösung angegriffen. Aufgrund der üblichen Dicken von Siliziumscheiben im Bereich zwischen 80 und 300 µm sind die Randflächen viel kleiner als die Flächen der ersten und zweiten Seite, sodass Auswirkungen der Texturätzlösung auf die Randflächen in der Darstellung der Fig. 1a vernachlässigt werden.

In einer bevorzugten Ausgestaltungsvariante des erfindungsgemäßen Verfahrens wird nach dem Ätzen 16 in der Texturätzlösung poröses Silizium 112 auf einen Teil der Oberfläche der Siliziumscheibe 112 aufgebracht. Besonders bevorzugt wird die gesamte Oberfläche der Siliziumscheibe 102 abgesehen von der ersten Seite 108 mit einer Schicht aus porösem Silizium 112 überzogen. So auch in dem in den Fig. 1a, 1b dargestellten Ausführungsbeispiel. Weiterhin sieht eine Variante der erfindungsgemäßen Verfahren vor, dass nach dem Aufbringen 18 des porösen Siliziums 112 die Siliziumscheibe 102 einer Phosphordiffusion unterzogen wird 20, wie es in der Fig. 1b schematisch dargestellt ist. Hierbei wird in an sich bekannter Weise ein Phosphorglas 114 zumindest auf demjenigen Teil der Oberfläche der Siliziumscheibe 112 ausgebildet, welcher nicht von porösem Silizium 102 überdeckt ist. Aus diesem Phosphorglas 114 wird während des Diffusionsvorganges Phosphor in die Siliziumscheibe 102 eindiffundiert, wodurch der Phosphor diffundierte Bereich 116 ausgebildet wird. Auch in den mit porösem Silizium überdeckten Bereichen kann es auf dem porösen Silizium zu einer Ausbildung von Phosphorglas kommen, welches während des Diffusionsvorganges als Phosphorquelle für eine Diffusion des Phosphors in die Siliziumscheibe 102 dient. Jedoch ist diese Diffusion durch das poröse Silizium 112 stark gehemmt, sodass nach einem nachfolgenden Ätzen des Phosphorglases sowie des porösen Siliziums auf der zweiten Seite sowie den Rändern idealerweise kein relevanter Phosphoreintrag in die Siliziumscheibe 102 verbleibt. Dies ist insbesondere dann realisierbar, wenn nur auf der ersten Seite 108 ein Phosphorglas 114 ausgebildet wird.

Gelangt jedoch bei entsprechender Prozessführung Phosphor aus dem Phosphorglas 114 durch das poröse Silizium 112 hindurch in die Ränder der Siliziumscheibe 102 hinein, so werden zu einem späteren Zeitpunkt die Ränder zumindest teilweise geätzt, vorzugsweise nasschemisch oder mit einem Plasma, um dort vorhandene phosphor-diffundierte Bereiche zu entfernen, so dass die erste Seite 108 von der zweiten Seite 110 elektrisch isoliert ist (Kantenisolation).

Wie im Ausführungsbeispiel der Fig. 1b dargestellt, wird das während der Phosphordiffusion entstandene Phosphorglas 114 vorzugsweise gemeinsam mit einer vorhandenen Schicht porösen Siliziums 112 entfernt. Dies ist jedoch nicht zwingend erforderlich.

In einer bevorzugten Ausgestaltungsvariante verbleibt das Borglas 104 während der Phosphordiffusion 20 auf der zweiten Seite 110 der Siliziumscheibe 102 und dient dort als Diffusionsbarriere für Phosphor. Das Borglas 104 wird sodann zu einem späteren Zeitpunkt entfernt, vorzugsweise gemeinsam mit dem Phosphorglas 114 und/oder der Schicht aus porösem Silizium 112. Dies kann beispielsweise in einem nasschemischen Ätzschritt erfolgen.

Alternativ besteht die Möglichkeit, das Borglas 104 vor dem Aufbringen 18 der Schicht aus porösem Silizium 112 zu entfernen. Kommt es während der nachfolgenden Phosphordiffusion 20 zu einem relevanten Eintrag von Phosphor auf die zweite Seite 110, so wird diese im Weiteren soweit zurückgeätzt, dass ein Bor-diffundierter Bereich 106 gewünschter Dotierung und Dicke verbleibt, der Phosphoreintrag auf der zweiten Seite 110 jedoch entfernt ist. Die Dicke des Borglases 104 bzw. des Bor-diffundierten Bereiches 106 vor der Phosphordiffusion 20 ist entsprechend anzupassen.

Im Weiteren wird die Siliziumscheibe 102 wenigstens auf der ersten 108 und der zweiten Seite 110, vorzugsweise auf der gesamten Oberfläche der Siliziumscheibe, mit einer dielektrischen Schicht 118 versehen 24. Im Ausführungsbeispiel der Fig. 1b wird hierzu auf der gesamten Oberfläche der Siliziumscheibe Siliziumnitrid abgeschieden, was beispielsweise mittels einer chemischen Niederdruckgasphasen-Abscheidung (LPCVD) erfolgen kann. Im weiteren werden Kontakte 120 auf die erste Seite 108 sowie weitere Kontakte 121 auf die Rückseite 110 aufgebracht 26. Dies kann neben Aufdampfen durch Aufdrucken metallhaltiger Pasten, z. B. Silber und/oder Aluminium enthaltende Pasten, verbunden mit einem anschließenden Einfeuern der Kontakte in die Siliziumscheibe 102, bei welchem die Dielektrikumschicht von den Kontakten 120, 121, durchdrungen wird, erfolgen. Die Pasten werden dabei vorzugsweise durch ein Druckverfahren, insbesondere durch Sieb-, Rollen- oder Spritzendruck, auf die Siliziumscheibe 102 aufgebracht.

Im Ergebnis ergibt sich eine Siliziumsolarzelle, welche eine Texturierung aufweist, sodass eine verbesserte Lichteinkopplung und damit ein höherer Wirkungsgrad erzielt wird, ohne dass ein aufwändiger Maskierungsschritt zum Aufbringen einer Maskierung, beispielsweise eines Lackes, erforderlich wäre, um diejenigen Bereiche vor der Texturätzlösung zu schützen, welche nicht texturiert werden sollen.

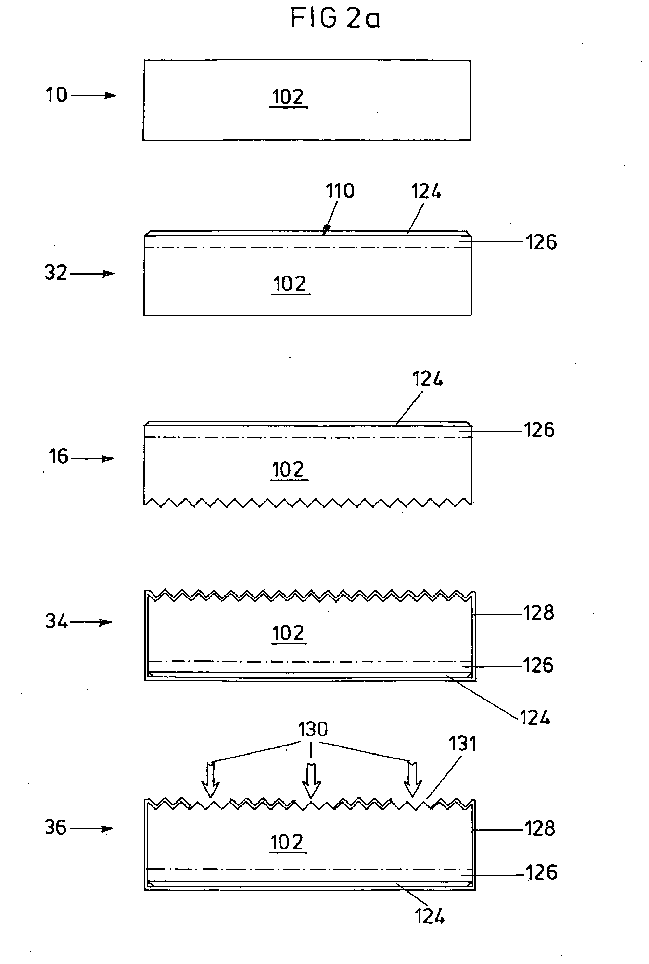

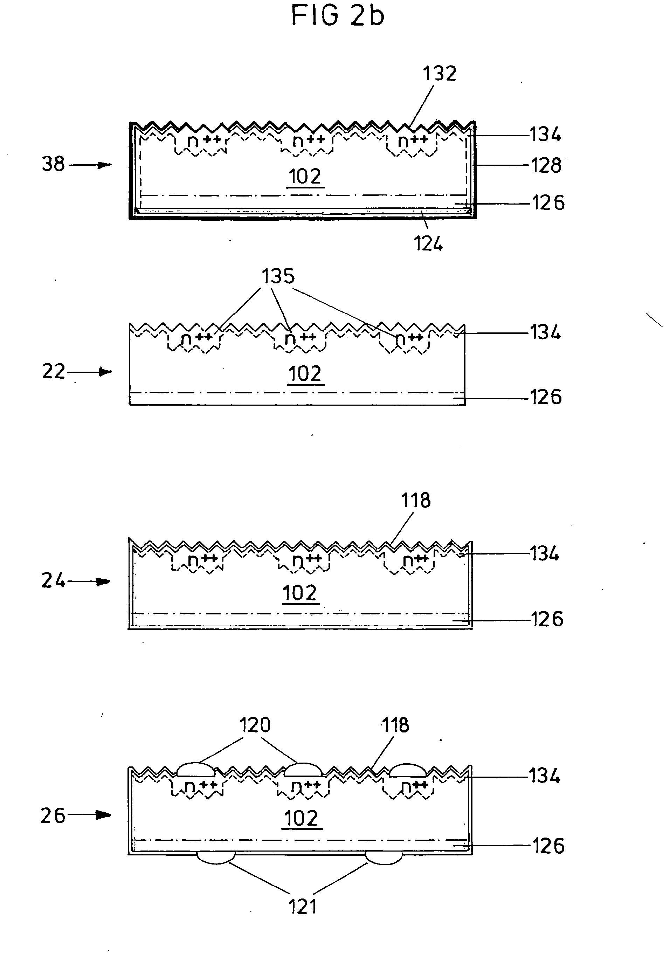

Die Fig. 2a und 2b zeigen eine weiter Ausgestaltungsvariante des erfindungsgemäßen Verfahrens bei welchem Borglas als Ätzbarriere eingesetzt wird. Zunächst wird die Siliziumscheibe 102 wiederum gereinigt 10. Es folgt wiederum die Ausbildung eines Borglases 124, was in diesem Ausführungsbeispiel jedoch nicht einen gewöhnlichen Bordiffusionsvorgang erfolgt, bei welchem die Siliziumscheibe 102 einer borhaltigen, gasförmigen Verbindung mit ihrer ganzen Oberfläche ausgesetzt wird. Stattdessen wird das Borglas 124 nur auf die zweite Seite 110 der Siliziumscheibe 102 aufgebracht 32. Dies erfolgt bei entsprechenden Ausgestaltungsvarianten des erfindungsgemäßen Verfahrens vorzugsweise mittels chemischer Abscheidung des Borglases aus einer Dampfphase, wobei diese Abscheidung besonders bevorzugt bei Atmosphärendruck erfolgt (APCVD). Alternativ ist das Aufbringen einer Bordiffusionsquelle mittels eines Aufspinn- oder eines Aufsprüh-Verfahrens möglich. Ein teilweises Entfernen des Borglases sowie darunter liegender Bor-diffundierter Bereiche wie im Falle des Ausführungsbeispiels der Fig. 1a und 1b kann somit entfallen, da von vornherein nur auf der zweiten Seite 110 Borglas 124 ausgebildet wird, aus welchem Bor in die Siliziumscheibe 102 eindiffundiert wird, sodass im Wesentlichen nur unter dem Borglas 124 ein Bor-diffundierter Bereich 126 ausgebildet wird.

Somit kann bereits im Folgeschritt die Siliziumscheibe 102 in einer Texturätzlösung geätzt werden 16. Im Weiteren wird gemäß der Darstellung in der Fig. 2a wiederum poröses Silizium 128 auf die Siliziumscheibe 102 aufgebracht 34, in dem Ausführungsbeispiel der Fig. 2a jedoch ganzflächig. In einem Folgeschritt wird poröses Silizium mittels Laserstrahlung 130 lokal entfernt 36. Hierdurch ergeben sich Öffnungen 131 in der porösen Siliziumschicht 128, welche bei der nachfolgenden Phosphordiffusion 38 einen starken Phosphoreintrag in die Siliziumscheibe 102 zulassen. Während der Phosphordiffusion wird wiederum ein Phosphorglas 132 ausgebildet, welches in den zuvor erzeugten Öffnungen 131 angeordnet ist. Direkt unter den Öffnungen 131 führt dies zu stark phosphordiffundierten Bereichen. In oberflächlich durch die Schicht aus porösem Silizium 128 geschützten Bereichen hingegen erfolgt nur ein schwacher Phosphoreintrag. Infolge ergibt sich ein durchgehend phosphor-diffundierter Bereich 134, welcher direkt unter den Öffnungen 131 stark diffundierte Bereiche aufweist, sodass eine selektive Emitterstruktur 134, 135 vorliegt.

Im Weiteren werden wiederum das Phosphorglas 132 sowie das poröse Silizium 128 geätzt 22, wie dies bereits näher im Zusammenhand mit Fig. 1b erläutert wurde. Vorzugsweise werden Phosphorglas 132 und poröses Silizium 128 wiederum gemeinsam entfernt. Zudem werden an den Rändern die phosphordiffundierten Bereiche zum Zwecke der Kantenisolation entfernt. Dies erfolgt vorzugsweise nasschemisch.

In einer bevorzugten Ausgestaltungsvariante der Erfindung verbleibt das Borglas 124, wie in den Figuren 2a und 2b dargestellt, während des Aufbringens 34 des porösen Siliziums 128 wie auch während der Phosphordiffusion 38 auf der Siliziumscheibe und dient dort in der bereits im Zusammenhang mit den Figuren 1a und 1b beschriebenen Weise als Diffusionsbarriere für Phosphor. Die Entfernung des Borglases 124 erfolgt in diesem Fall zu einem späteren Zeitpunkt, vorzugsweise gemeinsam mit der Entfernung des Phosphorglases 132 und/oder des porösen Siliziums 128.

Alternativ besteht die Möglichkeit, das Borglas 124 vor dem Aufbringen 34 des porösen Siliziums 128 zu entfernen, beispielsweise nasschemisch. Infolgedessen käme es bei der Phosphordiffusion 38 nicht nur zu einem Phosphoreintrag an der ersten Seite 108, sondern auch an der zweiten Seite 110 der Siliziumscheibe sowie an den Rändern. Aus diesem Grund wird die zweite Seite 110 in diesem Fall zu einem nach der Phosphordiffusion 38 gelegenen Zeitpunkt so weit zurückgeätzt, dass der Phosphoreintrag auf der zweiten Seite 110 entfernt ist und ein Bor-diffundierter Bereich 126 gewünschter Dotierung und gewünschter Dicke verbleibt. Die Dicke des Borglases 124 bzw. des Bor-diffundiernten Bereiches 126 vor der Phosphordiffusion 38 ist entsprechend zu wählen. Dieses Zurückätzen der zweiten Seite 110 erfolgt vorzugsweise gemeinsam mit der Entfernung der phosphordiffundierten Bereiche an den Rändern der.Siliziumscheibe 102 zum Zwecke der Kantenisolation. Besonders bevorzugt wird dies durch ein nasschemisches Ätzen realisiert.

Im Folgenden wird ganzflächig Siliziumnitrid aufgebracht. Des Weiteren werden Kontakte 120 auf die erste Seite 108 sowie Kontakte 121 auf die zweite Seite 110 aufgebracht 26. Beides wurde bereits im Zusammenhang mit Fig. 1b näher erläutert.

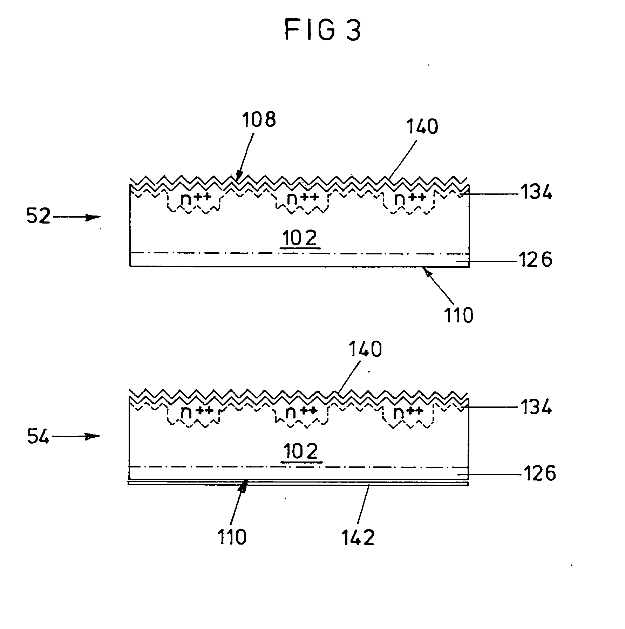

Neben einem ganzflächigen Aufbringen 24 von Siliziumnitrid 118 ist in alternativen Ausgestaltungsvarianten des erfindungsgemäßen Verfahrens vorgesehen, dass auf die erste Seite 108 und die zweite Seite 110 der Siliziumscheibe 102 verschiedene Dielektrika aufgebracht werden. Dies illustriert Fig. 3 schematisch. Dabei wird bevorzugt auf die erste Seite 108 als dielektrische Schicht Siliziumnitrid 140 aufgebracht 52, welches vorzugsweise mittels einer chemischen Niederdruckgasphasenabscheidung abgeschieden wird 52.

Auf der zweiten Seite 110 hingegen ist eine andere dielektrische Schicht aufgebracht 54. Als solche ist im Ausführungsbeispiel der Fig. 3 Siliziumdioxid 142 vorgesehen. Stattdessen kann jedoch auch beispielsweise Titandioxid oder Siliziumcarbid verwendet werden.

Das Aufbringen 26 von Kontakten 120, 121 erfolgt im Weiteren wie oben im Zusammenhang mit den Fig. 1a, 1b, 2a und 2b beschrieben.

Das Vorsehen von unterschiedlichen dielektrischen Schichten auf der ersten Seite 108 und der zweiten Seite 110 der Siliziumscheibe 102 ist nicht auf das Ausführungsbeispiel der Fig. 2a, 2b beschränkt. Offensichtlich kann beispielsweise auch in dem in den Fig. 1a und 1b dargestellten erfindungsgemäßen Verfahren das Abscheiden 24 von Siliziumnitrid auf der gesamten Oberfläche der Siliziumscheibe 102 durch das Aufbringen 52, 54 verschiedener dielektrischer Schichten gemäß der schematischen Darstellung in der Fig. 3 ersetzt werden.

Erfindungsgemäße Verfahren, bei welchen Borglas als Ätzbarriere verwendet wird, werden vorliegend stets in Verbindung mit Siliziumscheiben diskutiert. Anstelle von Silizium können jedoch auch andere Halbleiter Verwendung finden, beispielsweise Germanium.

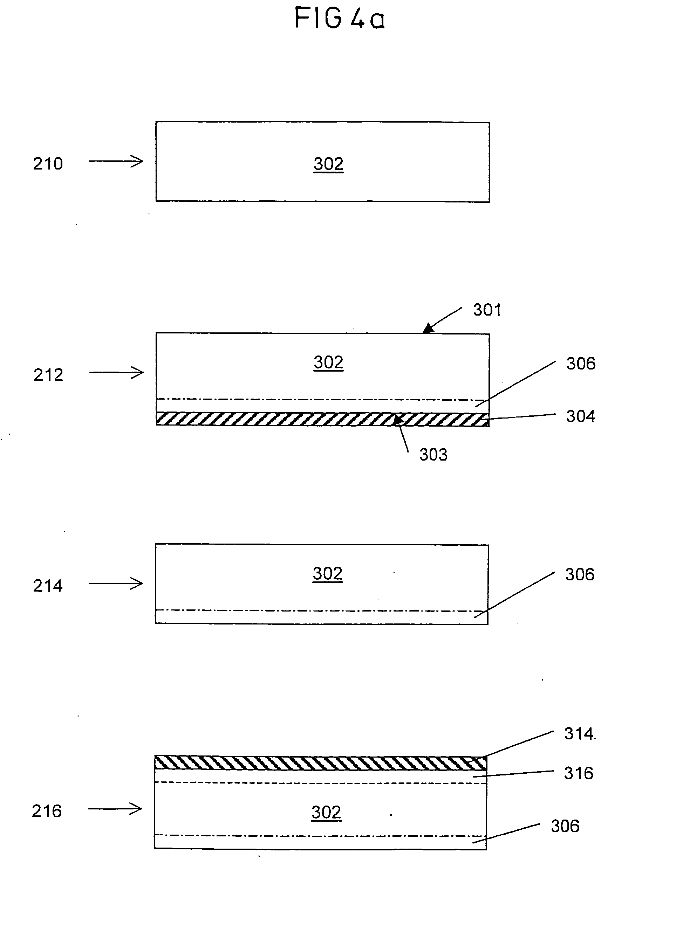

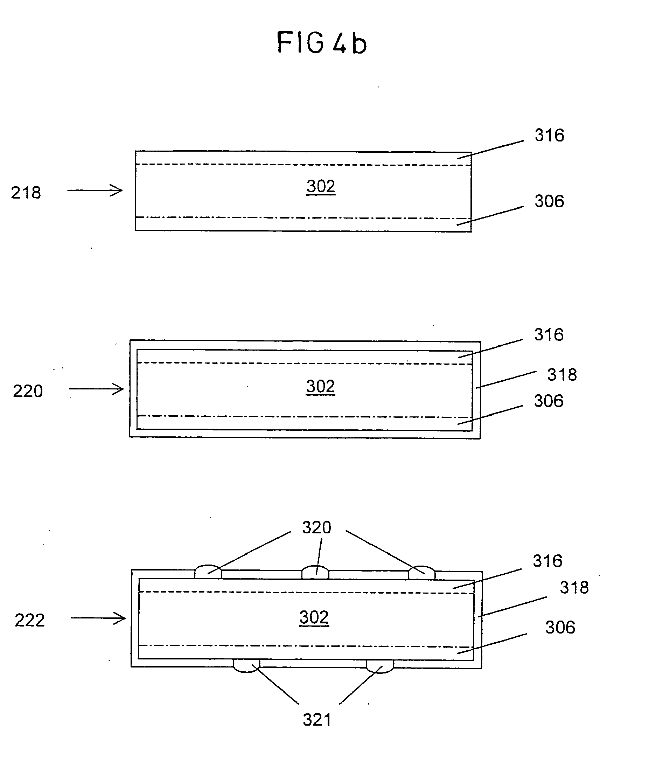

Die Fig. 4a und 4b illustrieren ein erfindungsgemäßes Verfahren, bei welchem ein Cogettern erfolgt. Zu Beginn wird eine Siliziumscheibe 302, üblicherweise auch als Wafer bezeichnet, gereinigt 210. Dies erfolgt üblicherweise durch Überätzen der Oberfläche der Siliziumscheibe 302, woran sich weitere chemische Reinigungsstufen anschließen können.

Im Weiteren wird bei dem erfindungsgemäßen Verfahren aluminiumhaltiges Material, im Ausführungsbeispiel der Fig. 4a gebildet durch eine kurz als Aluminiumpaste bezeichnete aluminiumhaltige Paste, auf einen Teil der Oberfläche der Siliziumscheibe 302 aufgebracht und einlegiert 212. Im Ausführungsbeispiel der Fig. 4a ist dieser Teil gebildet durch die gesamte zweite Seite 303 der Siliziumscheibe 302. Bei allen erfindungsgemäßen Verfahren kann das Aufbringen aluminiumhaltigen Materials grundsätzlich auf beliebige Weise erfolgen, insbesondere auch durch Platieren.

Unter Einlegieren im Sinne der vorliegenden Erfindung ist zu verstehen, dass das aluminiumhaltige Material samt dem daran angrenzenden Siliziumanteil der Siliziumscheibe auf eine Temperatur oberhalb der Eutektikumstemperatur des aus Aluminium und Silizium gebildeten Gemisches erhitzt wird. Beim nachfolgenden Abkühlen wird Aluminium in das Siliziumkristallgitter eingebaut und damit in die Siliziumscheibe einlegiert. Zudem wird an die Siliziumscheibe angrenzend eine Siliziumschicht ausgebildet, welche nur vergleichsweise wenig Aluminium enthält, typischerweise im Promillbereich, sodass hier von mit Aluminium dotiertem Silizium gesprochen wird. Diese dotierte Siliziumschicht bewirkt je nach Zelltyp, d. h. npp⁺- oder pnn⁺-Zelle, ein rückseitiges oder vorderseitiges, oberflächennahes, elektrisches Feld, welches üblicherweise als Back Surface Field oder Front Surface Field bezeichnet wird.

Ein solcher aluminiumdotierter Bereich 306 ist in Fig. 4a auf der zweiten Seite der Siliziumscheibe 302 ausgebildet und schematisch wiedergegeben.

Nach dem Einlegieren 212 des Aluminiums 304 in die Siliziumscheibe 302 werden bei dem erfindungsgemäßen Verfahren nicht einlegierte Aluminiumbestandteile sowie andere Bestandteil des aluminiumhaltigen Materials 304 von der Siliziumscheibe 302 entfernt 214. Im Ausführungsbeispiel der Fig. 4a erfolgt dies durch Abätzen 214 der Reste der Aluminiumpaste 304. Alternativ kann das aluminiumhaltige Material 304, bzw. die Aluminiumpaste 304, wasserlösliche Bestandteile enthalten, sodass nicht einlegierte Aluminiumbestandteile und andere Bestandteile des aluminiumhaltigen Materials 304 durch Wassereinwirkung entfernt werden können. Hierzu werden die Siliziumscheiben beispielsweise in ein Wasserbad gegeben oder Wasserstrahlen ausgesetzt. Daneben oder ergänzend besteht die Möglichkeit, das aluminiumhaltige Material 304 mit Bestandteilen zu versetzen, welche in einem anderen Lösungsmittel als Wasser löslich sind, beispielsweise in Alkoholen. Zur Entfernung nicht einlegierten Aluminiums und anderer Bestandteile werden die Siliziumscheiben 302 in diesem Fall entsprechenden Lösungsmitteln ausgesetzt. Gegebenenfalls werden die Siliziumscheiben in zeitlicher Abfolge verschiedenen Lösungsmitteln ausgesetzt.

Erfindungsgemäß wird nach dem Einlegieren 212 des Aluminiums 304, wie in Fig. 4a schematisch dargestellt, ein Phosphorglas 314 auf wenigstens einem weiteren Teil der Oberfläche der Siliziumscheibe 302 ausgebildet 216. Im Ausführungsbeispiel der Fig. 4a wird die gesamte erste Seite mit einem Phosphorglas 314 überzogen. Im Weiteren wird Phosphor aus dem Phosphorglas 314 in die Scheibe 302 eindiffundiert 216. Hierdurch wird ein phosphordiffundierter Bereich 316 ausgebildet 216. Grundsätzlich kann der zum Zwecke des Ausbildens des phosphordiffundierten Bereiches eine andere Phosphorquelle als das Phosphorglas 314 Verwendung finden. Beispielsweise kann Phosphor aus aufgebrachter Phosphorsäure genutzt werden. Im Ausführungsbeispiel der Fig. 4a wird das Phosphorglas 314 nur auf die erste Seite 301 der Siliziumscheibe 302 aufgebracht 216. Dies kann beispielsweise durch Aufspinnen einer phosphorhaltigen Paste oder Lösung und anschließende thermische Behandlung erfolgen, welche üblicherweise bei Temperaturen oberhalb von 800° C erfolgt.

Bei diesen Temperaturen sind in der Siliziumscheibe 302 enthaltene Verunreinigungen vergleichsweise beweglich und können durch injektions- oder segregationsinduziertes Gettern oder anderweitiges Getterprozesse in den aluminiumdotierten Bereich 306 oder in das Phosphorglas 314 gelangen. Durch dieses Cogettern in dem Phosphorglas 314 wie auch in dem aluminiumdotierten Bereich 306 können mehr rekombinationsaktive Verunreinigungen aus dem Volumen der Siliziumscheibe 302 entfernt werden. In dem aluminiumdotierten Bereich eingebunden sind sie weniger rekombinationsaktiv, in dem Phosphorglas eingebunden werden sie in einem nachfolgenden Ätzschritt entfernt. Infolgedessen rekombinieren weniger der in der Solarzelle durch Lichteinfall erzeugten Ladungsträger, was einen verbesserten Wirkungsgrad zur Folge hat verglichen mit einem Gettern allein in dem Phosphorglas.

Das bereits angesprochene Entfernen des Phosphorglases 214 erfolgt durch Ätzen 218 des Phosphorglases, wie in Fig. 4b schematisch angedeutet. Vorzugsweise wird dabei die Siliziumscheibe 302 nasschemisch geätzt.

In dem Ausführungsbeispiel der Fig. 4b wird im Weiteren über der gesamten Oberfläche der Siliziumscheibe 302 eine Schicht aus Siliziumnitrid 318 ausgebildet 220. Alternativ können für die verschiedenen Seiten der Siliziumscheibe unterschiedliche Dielektrika vorgesehen werden, beispielsweise Siliziumnitrid auf der ersten Seiten 301 und Siliziumcarbid auf der zweiten Seite 303. Eine Siliziumnitridschicht dient bekanntermaßen als Antireflexionsbeschichtung, zur Oberflächenpassivierung und kann darüber hinaus derart ausgebildet werden, dass sie Wasserstoff zur Passivierung des Volumens der Siliziumschreibe 302 freisetzt.

Zur Kontaktierung der Siliziumscheibe 302 bzw. der Solarzelle werden Kontakte 320, 321 auf die erste Seite 301 und die zweite Seite 303 der Siliziumscheibe 302 aufgebracht 22. Dies erfolgt bevorzugt durch Aufbringen metallhaltiger Pasten, insbesondere silber- und/oder aluminiumenthaltender Pasten. Diese werden beispielsweise mittels Siebdruck, Spritzendruck oder Rollendruck auf die Oberfläche aufgebracht und anschließend in einem Ofen durch die Siliziumnitridschicht 318 hindurch gefeuert, sodass sie mit der Siliziumscheibe 302 einen Ohmschen Kontakt bilden.

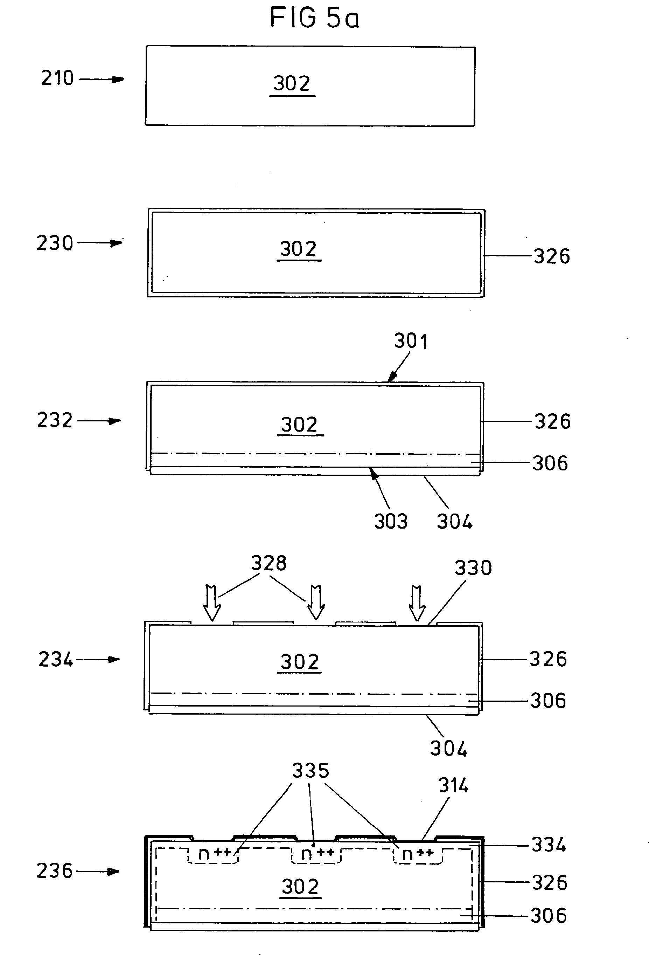

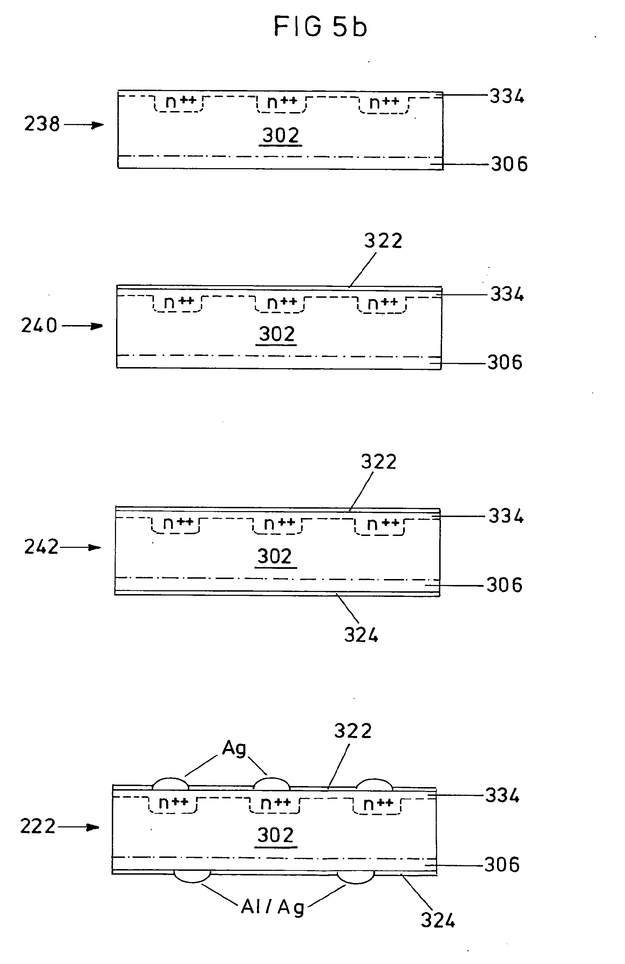

Die Fig. 5a und 5b illustrieren ein weiteres Ausführungsbeispiel eines erfindungsgemäßen Verfahrens, bei welchem ein Cogettern erfolgt. Zudem wird hier eine selektive Emitterstruktur ausgebildet. Ausgangspunkt bildet wiederum das Reinigen 210 der Siliziumscheibe mittels bekannter Ätz- bzw. Reinigungsverfahren. Im Weiteren wird auf der gesamten Oberfläche der Siliziumscheibe 302 eine Schicht aus porösem Silizium 326 ausgebildet 230. Nachfolgend wird wiederum auf die zweite Seite 303 der Siliziumscheibe 301 ein aluminiumhaltiges Material, im Ausführungsbeispiel der Fig. 5a eine aluminiumhaltige Paste 304, aufgebracht 232 und im obigen Sinne einlegiert. Der Einlegierungsvorgang wird teilweise auch als "Feuern" bezeichnet.

Im Folgenden wird das poröse Silizium 328 lokal entfernt 234. Dies geschickt vorzugsweise wie in Fig. 5a schematisch angedeutet, mittels Laserstrahlung 328, mit deren Hilfe das poröse Silizium 326 lokal entfernt wird.

Nachfolgend erfolgt eine thermische Behandlung, bei welcher eine Phosphordiffusion durchgeführt wird 236. Zur Durchführung der Phosphordiffusion kann, wie im Fall des Ausführungsbeispiel der Fig. 4a, nur auf die erste Seite 301 der Siliziumscheibe 302 ein Phosphorglas 314 aufgebracht werden, beispielsweise durch Aufspinnen einer phosphorhaltigen Paste. Alternativ kann das Phosphorglas auch durch eine phosphorhaltige, gasförmige Verbindung gebildet werden, welcher die Siliziumscheibe beispielsweise in einem Quarzrohr ausgesetzt wird.

Dass hierbei, abgesehen von der mit Aluminiumpaste bedeckten Oberfläche der Siliziumscheibe 302, die gesamte Oberfläche der Siliziumscheibe 302 mit Phosphorglas 314 bedeckt wird, ist unproblematisch, da dies zusammen mit dem porösen Silizium 326 in einem nachfolgenden Ätzschritt 238, vorteilhaft gemeinsam, entfernt werden kann. An den Rändern eindiffundiertes Phosphor wird zudem in einem weiteren Ätzschritt zur Isolation der Kanten entfernt.

Während der Phosphordiffusion 236 diffundiert Phosphor aus dem Phosphorglas 314, welches in Öffnungen 330 der Schicht aus porösem Silizium 326 angeordnet ist, in das Volumen der Siliziumscheibe 302 ein und bildet dort stark phosphordiffundierte Bereiche 335 aus. Durch das poröse Silizium 326 hindurch erfolgt eine vergleichsweise schwache Diffusion des Phosphors in die Siliziumscheibe 302 hinein, sodass auch in denjenigen Bereichen der Siliziumscheibe 302 eine Phosphordiffusion erfolgt, welche unter porösem Silizium 326 liegen. Infolgedessen ergibt sich ein durchgängiger phosphordiffundierter Bereich 334, in welchen die stark phosphordiffundierten Bereiche 335 eingebunden sind. Im Ergebnis erhält man damit eine selektive Emitterstruktur, welche bekanntermaßen eine Herstellung von Solarzellen mit erhöhtem Wirkungsgrad ermöglicht.

Da die Phosphordiffusion bei vergleichsweise hohen Temperaturen über 800° C erfolgt, werden gleichzeitig in der Siliziumscheibe 302 enthaltene Verunreinigungen in dem aluminiumdotierten Bereich 306 gegettert. Zudem kann während des Getterns eine Einlagerung von Verunreinigungen in dem Aluminium-Silizium-Gefüge erfolgen, welches sich beim Abkühlen unterhalb der Eutektikumstemperatur im Anschluss an den aluminiumdotierten Bereich 306 bildet. Weiterhin werden Verunreinigungen während des Phosphordiffusionsvorganges 236 in dem Phosphorglas 314 gegettert, wobei jedoch dieser Gettervorgang dadurch behindert ist, dass an der ersten Seite 301 der Siliziumscheibe 302 das Phosphorglas 314 teilweise durch poröses Silizium 326 von der Siliziumscheibe 302 getrennt ist. Eine Getterwirkung besteht dennoch, sodass wiederum ein Cogettern erfolgt.

Im Weiteren werden das Phosphorglas 314, das poröse Silizium 326 sowie die Aluminiumpaste 304, d. h. nicht einlegierte Aluminiumbestandteile sowie übrige Bestandteile der Aluminiumpaste 304, geätzt. Dies erfolgt vorzugsweise in einem gemeinsamen Ätzvorgang 238. An den Rändern eindiffundierter Phosphor wird in einem weiteren Ätzschritt zur Isolation der Kanten entfernt.

Nachfolgend wird gemäß einer bevorzugten Ausführungsvariante des erfindungsgemäßen Verfahrens eine Dielektrikumschicht 322 auf die erste Seite 301 der Siliziumscheibe 302 aufgebracht. 240. Dies erfolgt vorzugsweise mittels einer Plasmaabscheidung aus der Dampfphase. Alternativ kann beispielsweise als Dielektrikum auch eine Schicht aus Siliziumdioxid aufgebracht werden.

Zudem wird auf die zweite Seite 303 der Siliziumscheibe 302, auf welcher zuvor das aluminiumhaltige Material in Form der Aluminiumpaste 304 angeordnet war ebenfalls eine Dielektrikumschicht 324 aufgebracht 242. Vorzugsweise handelt es sich wieder um eine Schicht aus Siliziumnitrid 324, welche bevorzugt mittels einer chemischen Plasmaabscheidung aus der Dampfphase aufgebracht wird. Alternativ kann die Schicht aus Siliziumdioxid oder Siliziumcarbid gebildet sein, wobei die Siliziumcarbidschicht beispielsweise mittels chemischer Abscheidung aus der Dampfphase aufgebracht werden kann.

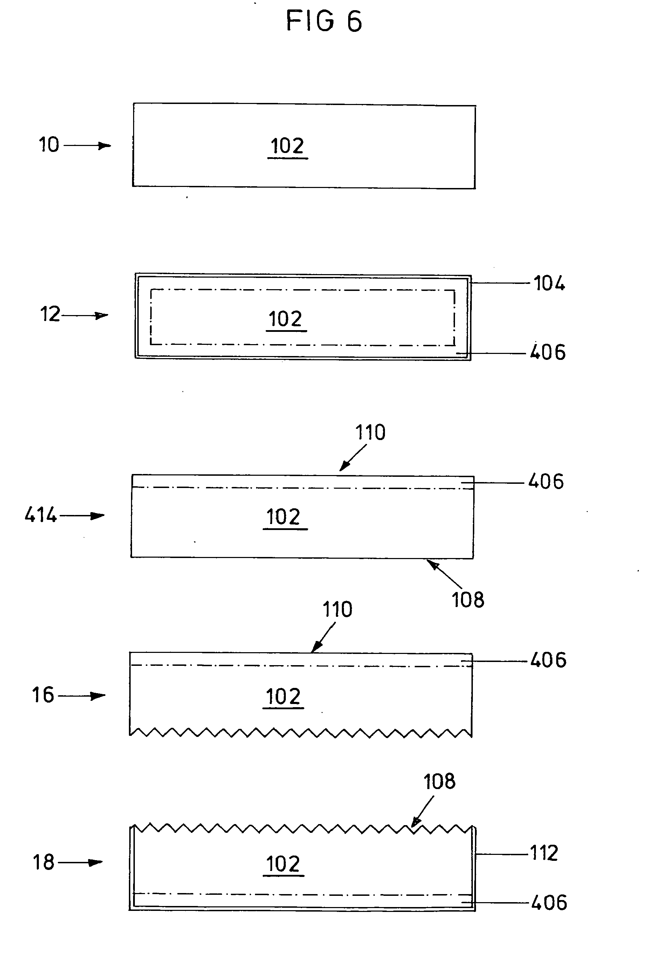

Figur 6 illustriert ein Ausführungsbeispiel eines erfindungsgemäßen Verfahrens, bei welchem eine hochdotierte Siliziumschicht als Ätzbarriere verwendet wird. Zunächst wird die Siliziumscheibe 102 auf die bereits im Zusammenhang mit Figur 1a beschriebene Weise gereinigt 10. Hierauf folgt die ebenfalls bereits in Verbindung Figur 1a erörterte Bordiffusion 12. Diese wird vorliegend derart durchgeführt, dass unter dem Borglas 104 eine mit Bor hochdotierte Siliziumschicht 406 ausgebildet wird. In dem dargestellten Ausführungsbeispiel der Figur 6 wird die mit Bor hochdotierte Siliziumschicht 406 auf der gesamten Oberfläche der Siliziumscheibe 102 ausgebildet. Alternativ ist auch eine lediglich einseitige Ausbildung denkbar. Mittels der Bordiffusion 12 wird vorzugsweise eine Bor-Dotandenkonzentra-tion in der hochdotierten Siliziumschicht realisiert, welche oberhalb von 10¹⁸ cm⁻³ liegt.

Im Weiteren wird das Borglas 104 vollständig, die hochdotierte Siliziumschicht 406 teilweise entfernt 414. Dies geschieht vorzugsweise durch in einem einheitlichen Ätzschritt mittels nasschemischem Ätzen oder Plasmaätzen. Es kann jedoch auch ein gestuftes Ätzen erfolgen, bei welchem zunächst das Borglas 104 und in einem weiteren Ätzschritt die hochdotierte Siliziumschicht 406 entfernt wird. Im Ausführungsbeispiel der Figur 6 wird das Borglas 104 auf der ersten Seite 108 und an den Rändern der Siliziumscheibe 102 entfernt. Auf der zweiten Seite 110 verbleibt hingegen die hochdotierte Siliziumschicht 406.

Diese verbleibende hochdotierte Siliziumschicht 406 dient im während des folgenden Ätzens 16 in einer Texturätzlösung als Ätzbarriere, sodass sich die in Figur 6 dargestellte Texturierung der Oberfläche der ersten Seite 108 ergibt. Als Texturätzlösung können die bereits im Zusammenhang mit Figur 1a diskutierten Ätzlösungen Verwendung finden. Die zweite Seite 110 wird während des Texturätzens 16 durch die dort vorhandene hochdotierte Siliziumschicht 406 vor dem Einwirken der Texturätzlösung hinreichend geschützt, sodass an dieser Stelle während über die für die Texturierung erforderliche Ätzdauer hinweg kein relevanter Abtrag der Siliziumscheibe 102 erfolgt. Die ungeschützten Randflächen hingegen werden von der Ätzlösung angegriffen, was in der Darstellung der Figur 6 analog wie in Figur 1a aufgrund der geringen Ausdehnung der Randflächen vernachlässigt wird.

Im Weiteren wird, wie bereits im Zusammenhang mit Figur 1a erläutert, poröses Silizium 112 als Diffusionsbarriere für die nachfolgende Phosphordiffusion 20 auf die Randflächen und die zweite Seite 110 der Siliziumscheibe 102 aufgebracht. Hinsichtlich des übrigen Verfahrensablaufs wird auf Figur 1b und die zugehörigen Ausführungen verwiesen.

Die erfindungsgemäßen Verfahren sind gleichermaßen für monokristallines wie auch multikristallines Silizium geeignet. Überdies können statt Siliziumscheiben auch Scheiben aus anderen Halbleitermaterialien, z. B. Germanium, verwendet werden.

### Bezugszeichenliste

- 10: Ätzen, Reinigen Siliziumscheibe
- 12: Bordiffusion ,
- 14: Teilweises Entfernen Borglas und Bor-dotierter Bereiche
- 16: Ätzen in Texturätzlösung
- 18: Aufbringen porösen Siliziums
- 20: Phosphordiffusion
- 22: Ätzen Phosphorglas/poröses Silizium
- 24: Abscheiden Siliziumnitrid
- 26: Aufbringen Kontakte
- 32: Abscheiden APCVD-Borglas/Bor-Eindiffusion
- 34: Aufbringen porösen Siliziums
- 36: Lokales Entfernen porösen Siliziums
- 38: Phosphordiffusion
- 52: Abscheiden Siliziumnitrid
- 54: Aufbringen Siliziumdioxid

- 102: Siliziumscheibe
- 104: Borglas
- 106: Bor-diffundierter Bereich
- 108: Erste Seite
- 110: Zweite Seite
- 112: Poröses Silizium
- 114: Phosphorglas
- 116: Phosphor-diffundierter Bereich
- 118: Siliziumnitrid
- 120: Kontakte erste Seite
- 121: Kontakte zweite Seite
- 124: Borglas
- 126: Bor-diffundierter Bereich
- 128: Poröses Silizium
- 130: Laserstrahlung
- 131: Öffnung
- 132: Phosphorglas
- 134: Phosphor-diffundierter Bereich
- 135: Stark Phosphor-diffundierter Bereich
- 140: Siliziumnitrid
- 142: Siliziumdioxid

- 210: Ätzen/Reinigen Siliziumscheibe
- 212: Aufbringen/Einlegieren Aluminiumpaste
- 214: Abätzen Reste Aluminiumpaste
- 216: Phosphordiffusion
- 218: Ätzen Phosphorglas
- 220: Siliziumnitrid
- 222: Aufbringen Kontakte

- 230: Ausbilden Schicht aus porösem Silizium
- 232: Aufbringen/Einlegieren Aluminiumpaste
- 234: Lokales Entfernen porösen Siliziums
- 236: Phosphordiffusion
- 238: Ätzen Phosphorglas, poröses Silizium, Aluminiumpaste
- 240: Aufbringen Siliziumnitrid
- 242: Abscheiden Siliziumnitrid

- 301: Erste Seite
- 302: Siliziumscheibe
- 303: Zweite Seite
- 304: Aluminiumpaste
- 306: Aluminium dotierter Bereich
- 314: Phosphorglas
- 316: Phosphor-diffundierter Bereich
- 318: Siliziumnitrid
- 320: Kontakte erste Seite
- 321: Kontakte zweite Seite
- 322: Siliziumnitrid (PECVD)
- 324: Siliziumnitrid (PECVD)
- 326: Poröses Silizium
- 328: Laserstrahlung
- 330: Öffnung
- 334: Phosphor-diffundierter Bereich
- 335: Stark Phosphor-diffundierter Bereich

- 406: hochdotierte Siliziumschicht
- 414: Entfernen Borglas und teilweises Entfernen hochdotierte Siliziumschicht

## Patentansprüche

1. Verfahren zur Herstellung von Solarzellen aufweisend folgende Verfahrensschritte :
Aufbringen (12; 32) von Borglas (104; 124) auf wenigstens einen Teil der Oberfläche einer Siliziumscheibe (102),
**dadurch gekennzeichnet, dass** während eines Ätzens (16) der Siliziumscheibe (102) in einer Texturätzlösung das Borglas (104; 124) als Ätzbarriere verwendet wird.

2. Verfahren nach Anspruch 1,
**dadurch gekennzeichnet, dass** das Borglas (104) auf die gesamte Oberfläche der Siliziumscheibe (102) aufgebracht (12) und nachfolgend vor dem Ätzen (16) in der Texturätzlösung teilweise entfernt wird (14).

3. Verfahren nach Anspruch 2,
**dadurch gekennzeichnet, dass** zur Ausbildung des Borglases (104) die Siliziumscheibe 102 in einem Diffusionsofen einer borhaltigen, gasförmigen Verbindung ausgesetzt wird (12).

4. Verfahren nach einem Ansprüche 2 bis 3,
**dadurch gekennzeichnet, dass** das Borglas (104) auf einer ersten Seite (108) der Siliziumscheibe (102) wenigstens teilweise entfernt wird (14).

5. Verfahren nach einem der Ansprüche 2 bis 4,
**dadurch gekennzeichnet, dass** das Borglas 104 nasschemisch entfernt wird (14).

6. Verfahren nach einem der Ansprüche 2 bis 4,
**dadurch gekennzeichnet, dass** das Borglas (104) mittels Laserstrahlung (130) entfernt wird (14), vorzugsweise an mehreren Stellen lokal.

7. Verfahren nach einem der Ansprüche 2 bis 6,
**dadurch gekennzeichnet, dass** in denjenigen Bereichen, in denen das Borglas (104) entfernt wird (14), darunter liegende Bereiche (106) der Siliziumscheibe (102), in welche Bor aus dem Borglas (104) eindiffundiert wurde, ebenfalls entfernt werden (14).

8. Verfahren nach Anspruch 1,
**dadurch gekennzeichnet, dass** auf eine zweite Seite (110) der Siliziumscheibe (102) Borglas (124) aufgebracht wird (32), vorzugsweise mittels chemischer Abscheidung aus einer Dampfphase bei Atmosphärendruck.

9. Verfahren nach Anspruch 8,
**dadurch gekennzeichnet, dass** Bor (126) aus dem Borglas (124) in die zweite Seite (110) der Siliziumscheibe (102) eindiffundiert wird (32).

10. Verfahren nach einem der Ansprüche 1 bis 9,
**dadurch gekennzeichnet, dass** eine alkalische Texturätzlösung verwendet wird, vorzugsweise eine welche Kaliumhydroxid und Isopropylalkohol enthält.

11. Verfahren nach einem der Ansprüche 1 bis 10,
**dadurch gekennzeichnet, dass** nach dem Ätzen (16) in der Texturätzlösung poröses Silizium (112) zumindest auf einen Teil der Oberfläche der Siliziumscheibe (102) aufgebracht wird (18), vorzugsweise auf die gesamte Oberfläche ausgenommen die erste Seite (108) der Siliziumscheibe (102).

12. Verfahren nach einem der Ansprüche 1 bis 10,
**dadurch gekennzeichnet, dass** auf die gesamte Oberfläche der Siliziumscheibe (102) poröses Silizium (128) aufgebracht wird (34), welches lokal, vorzugsweise auf der ersten Seite (108) der Siliziumscheibe (102), mittels Laserstrahlung (130) geöffnet (36) wird.

13. Verfahren nach einem der Ansprüche 1 bis 12,
**dadurch gekennzeichnet, dass** nach dem Ätzen (16) in der Texturätzlösung oder nach dem Aufbringen (18; 34) porösen Siliziums (112; 128) die Siliziumscheibe (102) einer Phosphordiffusion unterzogen wird (20; 38).

14. Verfahren nach Anspruch 13,
**dadurch gekennzeichnet, dass** während der Phosphordiffusion entstandenes Phosphorglas (114; 132) nasschemisch entfernt wird (22), vorzugsweise gemeinsam mit dem porösen Silizium (112; 128).

15. Verfahren nach einem der Ansprüche 1 bis 14,
**dadurch gekennzeichnet , dass** als Ätzbarriere verwendetes Borglas (104; 124) als dielektrische Schicht zumindest teilweise auf der Oberfläche der Siliziumscheibe (102) belassen wird.

16. Verfahren nach einem der Ansprüche 13 bis 15,
**dadurch gekennzeichnet, dass** die Siliziumscheibe (102) wenigstens auf der ersten (108) und der zweiten (110), vorzugsweise auf der gesamten Oberfläche, mit einer dielektrischen Schicht (118) versehen wird (24).

17. Verfahren nach Anspruch 16,
**dadurch gekennzeichnet, dass** als dielektrische Schicht (118) zumindest für die erste Seite (108) der Siliziumscheibe (102), bevorzugt für die erste (108) und die zweite Seite (110), Siliziumnitrid (118; 140) verwendet wird (24; 52), welches vorzugsweise mittels einer chemischen Niederdruckgasphasenabscheidung aufgebracht wird (52).

18. Verfahren nach Anspruch 16,
**dadurch gekennzeichnet, dass** als dielektrische Schicht auf die zweite Seite (110) der Siliziumscheibe (102) Titandioxid oder Siliziumdioxid (142) aufgebracht wird (54).

19. Verfahren zur Herstellung von Solarzellen aufweisend folgende Verfahrensschritte:
Ausbilden einer hoch dotierten Siliziumschicht (406) auf wenigstens einem Teil der Oberfläche einer Siliziumscheibe (102),
**dadurch gekennzeichnet, dass** während eines Ätzens (16) der Siliziumscheibe (102) in einer Texturätzlösung die hochdotierte Siliziumschicht (406) als Ätzbarriere verwendet wird.

20. Verfahren nach Anspruch 19,
**dadurch gekennzeichnet , dass** eine hochdotierte Siliziumschicht (406) mit einer Dotandenkonzentration größer als 10¹⁸ cm⁻³ ausgebildet wird.

21. Verfahren zur Herstellung von Solarzellen mit folgenden Verfahrensschritten:
- Aufbringen (212; 232) von aluminiumhaltigem Material (304) auf einen Teil der Oberfläche einer Siliziumscheibe (302);
- wenigstens teilweises Einlegieren (212; 232) des Aluminiums (304) in die Siliziumscheibe (302);
**dadurch gekennzeichnet, dass** nach dem wenigstens teilweisen Einlegieren (212; 236) des Aluminiums (304) ein Phosphorglas (314) auf wenigstens einem weiteren Teil der Oberfläche der Siliziumscheibe (302) ausgebildet und Phosphor in die Siliziumscheibe (302) eindiffundiert wird (216; 236), wobei in der Siliziumscheibe (302) enthaltene Verunreinigungen in dem Phosphorglas (314) und einem beim Einlegieren (212; 236) des Aluminiums (304) gebildeten aluminiumdotierten Bereich (306) gegettert werden.

22. Verfahren nach Anspruch 21,
**dadurch gekennzeichnet, dass** das aluminiumhaltige Material (304) aufgedampft, aufgesponnen oder mittels Sieb-, Rollen- oder Spritzendruck aufgedruckt wird (212; 232).

23. Verfahren nach einem der Ansprüche 21 bis 22,
**dadurch gekennzeichnet, dass** als aluminiumhaltiges Material (304) eine Aluminium enthaltende Paste (304) verwendet wird.

24. Verfahren nach einem der Ansprüche 21 bis 23,
**dadurch gekennzeichnet, dass** das nicht einlegierte Aluminium (304) und andere Bestandteile des aluminiumhaltigen Materials (304) durch nasschemisches Ätzen, vorzugsweise in einer Salzsäure enthaltenden Lösung, entfernt werden (214; 238).

25. Verfahren nach einem der Ansprüche 21 bis 23,
**dadurch gekennzeichnet, dass** das nicht einlegierte Aluminium (304) und andere Bestandteile des aluminiumhaltigen Materials (304) durch Plasmaätzen entfernt werden (214; 238).

26. Verfahren nach einem der Ansprüche 21 bis 23,
**dadurch gekennzeichnet, dass** das aluminiumhaltige Material (304) wasserlösliche Bestandteile enthält und nicht einlegiertes Aluminium (304) und andere Bestandteile des aluminiumhaltigen Materials (304) durch Wassereinwirkung entfernt werden, vorzugsweise in einem Wasserbad oder mittels Wasserstrahlen.

27. Verfahren nach einem der Ansprüche 21 bis 26,
**dadurch gekennzeichnet, dass** das aluminiumhaltige Material (304) auf eine zweite Seite (303) der Siliziumscheibe (302) aufgebracht (212; 232) und das Phosphorglas (314) auf einer ersten Seite (301) der Siliziumscheibe (302) ausgebildet wird (216; 236).

28. Verfahren nach einem der Ansprüche 21 bis 27,
**dadurch gekennzeichnet, dass** nicht einlegiertes Aluminium (304) und andere Bestandteile des aluminiumhaltigen Materials (304) vor dem Ausbilden (216) des Phosphorglases (314) entfernt werden (214).

29. Verfahren nach einem der Ansprüche 21 bis 27,
**dadurch gekennzeichnet, dass** nicht einlegiertes Aluminium (304) und andere Bestandteile des aluminiumhaltigen Materials (304) nach dem Ausbilden (236) des Phosphorglases (314) entfernt werden (238), wobei vorzugsweise gleichzeitig auch das Phosphorglas (314) entfernt wird (238).

30. Verfahren nach einem der Ansprüche 21 bis 29,
**dadurch gekennzeichnet, dass** zur Ausbildung (216; 236) des Phosphorglases (314) die Siliziumscheibe (302) einer phosphorhaltigen gasförmigen Verbindung ausgesetzt oder eine phosphorhaltige Substanz zumindest auf Teile der Oberfläche der Siliziumscheibe 302 aufgebracht, vorzugsweise aufgesponnen oder aufgedruckt wird.

31. Verfahren nach einem der Ansprüche 21 bis 30,
**dadurch gekennzeichnet , dass** die Phosphorglasbildung (216; 236) im Wesentlichen im selben thermischen Prozessschritt erfolgt wie die Eindiffusion von Phosphor aus dem Phosphorglas (314) in die Siliziumscheibe (302).

32. Verfahren nach einem der Ansprüche 21 bis 31,
**dadurch gekennzeichnet, dass** eine p-dotierte Siliziumscheibe (302) verwendet wird und bei der Eindiffusion (216; 236) des Phosphors aus dem Phosphorglas (314) ein Emitter ausgebildet wird.

33. Verfahren nach einem der Ansprüche 21 bis 31,
**dadurch gekennzeichnet, dass** eine n-dotierte Siliziumscheibe (302) verwendet wird und bei der Eindiffusion (216; 236) des Phosphors aus dem Phosphorglas (314) ein frontseitiges elektrisches Feld ausgebildet wird.

34. Verfahren nach einem der Ansprüche 21 bis 33,
**dadurch gekennzeichnet, dass** vor dem Aufbringen (212; 232) der aluminiumhaltigen Paste (304) auf der Oberfläche der Siliziumscheibe (302) poröses Silizium (326) ausgebildet wird (230), welches sich vorzugsweise über die gesamte Oberfläche der Siliziumscheibe (302) erstreckt.

35. Verfahren nach Anspruch 34,
**dadurch gekennzeichnet, dass** das poröse Silizium (326) vor dem Ausbilden (236) des Phosphorglases (314) an mindestens einer Stelle lokal entfernt wird (234), vorzugsweise mittels Laserstrahlung (328), und Phosphorglas (314) in einer an der mindestens einen Stelle erhaltenen Öffnung (330) ausgebildet wird (236).

36. Verfahren nach einem der Ansprüche 21 bis 35,
**dadurch gekennzeichnet, dass** nach einem Entfernen (218; 238) des Phosphorglases (314) eine Dielektrikumschicht (318; 322), vorzugsweise eine Schicht aus Siliziumnitrid (318) oder Siliziumdioxid, auf die erste Seite (301) der Siliziumscheibe (302) aufgebracht wird (220; 240).

37. Verfahren nach einem der Ansprüche 21 bis 36,
**dadurch gekennzeichnet, dass** nach Entfernen (214; 238) des nicht einlegierten Aluminiums (304) und anderer Bestandteile des aluminiumhaltigen Materials (304) eine Dielektrikumschicht (318; 324), vorzugsweise eine Schicht aus Siliziumnitrid (318; 324) oder Siliziumdioxid, oder eine Schicht aus Siliziumcarbid auf die zuvor von aluminiumhaltigem Material bedeckten Bereiche der Siliziumscheibe (302) aufgebracht wird (220; 242).

38. Vorrichtung aufweisend Mittel zur Durchführung eines der vorgenannten Verfahren.

39. Vorrichtung nach Anspruch 38,
**gekennzeichnet durch** eine Steuereinrichtung zur Ansteuerung der Vorrichtung gemäß einem Verfahren nach einem der Ansprüche 1 bis 37.

40. Solarzelle hergestellt mit einem Verfahren nach einem der Ansprüche 1 bis 35.

41. Solarzelle aufweisend:
- eine Siliziumscheibe (102);
- eine Textur auf einer ersten Seite (108) der Siliziumscheibe (102);
- eine erste dielektrische Schicht (140) auf der ersten Seite (108) der Siliziumscheibe (102);
**gekennzeichnet durch**
- einen auf einer zweiten Seite (110) der Siliziumscheibe (102) angeordneten Bor-diffundierten Bereich (106; 126) der Siliziumscheibe (102);
- eine aus einem anderen Material als die erste dielektrische Schicht (140) ausgebildete zweite dielektrischen Schicht (142),
- welche auf der zweiten Seite (110) der Siliziumscheibe (102) auf dem Bor-diffundierten Bereich (106; 126) angeordnet ist.

42. Solarzelle nach Anspruch 41,
**dadurch gekennzeichnet, dass**
- die erste dielektrische Schicht (140) gebildet ist aus Siliziumnitrid (140) und
- die zweite dielektrische Schicht (142) gebildet ist aus einem Material aus der Gruppe umfassend Siliziumdioxid (142), Titandioxid und Siliziumcarbid.
